# DEMANDE DE BREVET EUROPEEN

(11) **EP 4 761 520 A1**
(43) Date de publication de la demande: **17.06.2026**
(21) Numéro de dépôt: 25221833.4
(22) Date de dépôt: 09.12.2025
(51) Int. Cl.: H10F 19/80

(54) **MODULE PHOTOVOLTAÏQUE ET PROCÉDÉ DE FABRICATION D'UN TEL MODULE PHOTOVOLTAÏQUE**

(30) Priorité: 12.12.2024 FR 2413982
(71) Demandeur: Commissariat à l'Energie Atomique et aux Energies Alternatives, 75015 Paris (FR)
(72) Inventeur: CHAMBION, Bertrand, 38054 Grenoble Cedex 09 (FR); COMMAULT, Benjamin, 38054 Grenoble Cedex 09 (FR)
(74) Mandataire: Hautier IP

(57) **Abrégé**

L'invention concerne un module photovoltaïque (1), comprenant une première couche de protection (11) présentant une face interne (11b), une unité photovoltaïque (10) présentant une première (10a) et une deuxième (10b) face externe et une deuxième couche de protection (12) présentant une face interne (12a), caractérisé en ce que les couches de protection forment un logement (14) au sein duquel sont placés l'unité et au moins un dispositif de fixation (13) et en ce que une face externe de l'unité comprend une première zone (140) et une deuxième zone (141), l'au moins un dispositif de fixation présente une zone de recouvrement (131) en contact avec la deuxième zone et présente une surface inférieure ou égale à 10% de la surface de l'au moins une face externe permettant un déplacement d'une face interne au sein du logement.

## Description

### DOMAINE TECHNIQUE

La présente invention concerne le domaine des panneaux photovoltaïques. Elle trouve pour application particulièrement avantageuse le domaine de l'assemblage de module photovoltaïque, et plus particulièrement les modules photovoltaïques à haute résistance mécanique.

### ETAT DE LA TECHNIQUE

Il existe plusieurs structures et procédures d'assemblage d'un module photovoltaïque. En général la structure d'un module photovoltaïque standard comprend des cellules photovoltaïques noyées entre deux films d'encapsulation, une face avant ou première couche de protection composée d'un verre solaire trempé, une face arrière ou deuxième couche de protection en polymère ou en verre trempé. Un module comprend en outre une boite de jonction qui permet d'interconnecter les modules pour produire un courant.

Ces différentes couches sont mises en œuvre par un procédé de lamination à chaud (environ 150°C) sous vide. L'ensemble est ensuite cadré à l'aide d'un cadre aluminium. Cette structure est devenue aujourd'hui un standard qui possède un poids relativement élevé qui n'est pas adapté pour certaines applications.

Dans le cas d'applications où la légèreté est une priorité, les modules photovoltaïques avec du verre épais en face avant ne sont plus compatibles. Une solution est alors de remplacer le verre épais de la face avant par des matériaux plastiques, tels des feuilles polymères plus légères. Cependant, lorsqu'on se contente de remplacer le verre par cette feuille mince, la cellule devient très vulnérable au choc, à la charge mécanique et aux dilatations différentielles.

Une solution décrite dans le brevet CN114725232A propose une couche tampon épaisse permettant une meilleure résistance aux chocs. Cependant cette solution ne permet pas de limiter les fissures et les cassures des cellules en cas de charge mécanique et de dilations différentielles.

Un objet de la présente invention est donc de proposer une solution permettant d'améliorer la résistance aux chocs et la résistance thermomécanique d'un module photovoltaïque.

### RESUME

Pour atteindre cet objectif, selon un premier aspect on prévoit un module photovoltaïque, comprenant un empilement comportant successivement selon une direction, dite d'empilement, au moins :
- une première couche de protection,
- une unité photovoltaïque, l'unité photovoltaïque comprenant une couche d'encapsulant et une chaîne de cellules photovoltaïques électriquement interconnectées, la chaîne de cellules photovoltaïques étant au moins en partie noyée au sein de la couche d'encapsulant ; et
- une deuxième couche de protection,

les première et deuxième couches de protection présentant respectivement deux faces internes tournées en regard et vers l'unité photovoltaïque, la couche d'encapsulant présentant une première face externe tournée au regard de la face interne de la première couche de protection et une deuxième face externe tournée en regard et vers la face interne de la deuxième couche de protection,
caractérisé en ce que le module photovoltaïque comprend au moins un dispositif de fixation situé entre au moins une face externe de l'unité photovoltaïque et la face interne tournée en regard et vers ladite au moins une face externe, les première et deuxième couches de protection forment un logement, le logement étant délimité par la face interne de la première couche et par la face interne de la deuxième couche, au sein duquel sont placés l'unité photovoltaïque et ledit au moins un dispositif de fixation, ledit au moins un dispositif de fixation étant au contact de ladite au moins une face externe de l'unité photovoltaïque et de ladite face interne et en ce que ladite au moins une face externe de l'unité photovoltaïque comprend une première zone située au droit, selon une direction parallèle à la direction d'empilement, de la chaîne de cellules photovoltaïques, et une deuxième zone entourant la première zone, ledit au moins un dispositif de fixation présente une zone de recouvrement en contact avec ladite au moins une face externe de l'unité photovoltaïque, la zone de recouvrement étant au moins en contact avec la deuxième zone et présente une surface inférieure ou égale à 10% de la surface de ladite au moins une face externe de l'unité photovoltaïque, le dispositif de fixation étant configuré pour permettre un déplacement de ladite face interne au sein du logement.

Ainsi, l'invention propose une solution afin d'améliorer la résistance thermomécanique d'un module photovoltaïque. En minimisant la surface de la zone de recouvrement, on limite les transferts de déformation des couches de protection sur l'unité photovoltaïque. En outre, en minimisant la surface de la zone de recouvrement, on utilise moins de matière pour alléger davantage le module photovoltaïque. Un tel dispositif de fixation permet de découpler le comportement mécanique entre les couches de protection et l'unité photovoltaïque. Ainsi, par exemple, en cas de choc sur une des couches de protection, la couche de protection pourra se déformer tout en minimisant, voire en supprimant, une déformation des cellules photovoltaïques. En particulier, on limite avantageusement qu'une déformation de la couche de protection impose une déformation de la couche d'encapsulant. On empêche ainsi l'apparition de fissures ou de fractures des cellules. On limite ainsi une perte de performance du module photovoltaïque. Avantageusement, les première et deuxième couches de protection permettent de créer une coque de protection autour des cellules photovoltaïques afin de s'assurer de la résistance aux chocs thermomécanique du module photovoltaïque.

Selon un autre aspect on prévoit un procédé de fabrication d'un module photovoltaïque, comprenant une fourniture d'un empilement, l'empilement comportant successivement selon une direction, dite d'empilement, au moins :
- une première couche de protection,
- une unité photovoltaïque, l'unité photovoltaïque comprenant une couche d'encapsulant et une chaîne de cellules photovoltaïques électriquement interconnectées, la chaîne de cellules photovoltaïques étant au moins en partie noyée au sein de la couche d'encapsulant ; et
- une deuxième couche de protection,

les première et deuxième couches de protection présentant respectivement deux faces internes tournées au regard de l'unité photovoltaïque, la couche d'encapsulant présentant une première face externe tournée au regard de la face interne de la première couche de protection et une deuxième face externe tournée au regard de la face interne de la deuxième couche de protection,
caractérisé en ce que le procédé comprend un placement d'au moins un dispositif de fixation entre au moins une face externe de l'unité photovoltaïque et la face interne tournée au regard de ladite au moins une face externe, les première et deuxième couches de protection forment un logement, le logement étant délimité par la face interne de la première couche et par la face interne de la deuxième couche, au sein duquel un placement de l'unité photovoltaïque et dudit au moins un dispositif de fixation est réalisé, ledit au moins un dispositif de fixation étant placé au contact de ladite au moins une face externe de l'unité photovoltaïque et de ladite face interne et de sorte que ladite au moins une face externe de l'unité photovoltaïque comprend une première zone située au droit, selon une direction parallèle à la direction d'empilement, de la chaîne de cellules photovoltaïques, et une deuxième zone entourant la première zone, ledit au moins un dispositif de fixation présente une zone de recouvrement en contact avec ladite au moins une face externe de l'unité photovoltaïque, la zone de recouvrement étant au moins en contact avec la deuxième zone et présente une surface inférieure ou égale à 10% de la surface de ladite au moins une face externe de l'unité photovoltaïque, le dispositif de fixation étant configuré pour permettre un déplacement de ladite face interne au sein du logement.

Ainsi, l'assemblage du module photovoltaïque consiste en un assemblage de différentes couches facilement réalisable tout en améliorant la résistance aux chocs et la résistance thermomécanique des modules.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente une vue en coupe du module photovoltaïque selon un mode de réalisation, le module photovoltaïque étant au moins en parti assemblé.
La figure 2 représente une vue en coupe du module photovoltaïque selon un mode de réalisation, le module photovoltaïque étant assemblé.
La figure 3 représente une vue en coupe du module photovoltaïque selon un autre mode de réalisation, le module photovoltaïque étant assemblé.
La figure 4 représente une vue en coupe du module photovoltaïque selon un autre mode de réalisation, le module photovoltaïque étant en cours d'assemblage.
La figure 5 représente une vue de dessus d'un autre mode de réalisation d'un module photovoltaïque de sorte à former un panneau photovoltaïque.
Les figures 6A et 6B représentent des vues d'un module selon d'autres modes de réalisation.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement.

Selon un exemple, ledit au moins un dispositif de fixation est au contact de ladite au moins une face externe de l'unité photovoltaïque et de ladite face interne. Ainsi, on simplifie la fabrication du module. Avantageusement on évite de placer de la matière entre le dispositif de fixation et l'unité photovoltaïque pour alléger le module. De plus une étape de lamination lors de l'assemblage n'est pas nécessaire, ce qui simplifie davantage la fabrication du module.

Selon un exemple, le logement est configuré de sorte à présenter un volume supérieur à celui de l'unité photovoltaïque et de sorte à créer un volume de séparation entre l'unité photovoltaïque et le première couche de protection et/ou la deuxième couche de protection.

Selon un exemple, le volume de séparation est configuré de sorte à contenir un fluide compressible. Cela permet à au moins une couche de protection de se déformer dans le volume de séparation en réponse à une déformation thermomécanique, ou à des chocs sur la couche de protection, sans impacter les cellules photovoltaïques. On évite ainsi que les cellules photovoltaïques soient endommagées et on limite les pertes de performance.

Selon un exemple, le fluide compressible est pris parmi un gaz ou un liquide. Le gaz ou le liquide compressible pourra alors permettre d'autoriser un déplacement d'une couche de protection en cas de contrainte thermique et/ou mécanique afin de minimiser un déplacement de la couche d'encapsulant.

Selon un exemple, le volume de séparation est configuré de sorte à être rempli d'air. Afin d'améliorer la résistance thermomécanique du module photovoltaïque, l'utilisation de l'air permet de faciliter l'assemblage.

Selon un exemple, une couche de protection comprend un évent et une membrane anti-retour configurés pour permettre une évacuation du fluide compressible, de préférence du gaz, vers l'extérieur du module photovoltaïque. Cela permet, d'évacuer le fluide présent dans le volume de séparation qui pourrait être mis sous pression lors des différents changements thermiques du module photovoltaïque. La membrane anti-retour permet ainsi de réaliser un équilibrage des pressions partielles, de préférence des pressions partielles relatives.

Selon un exemple, la zone de recouvrement présente, en outre, une partie de recouvrement en contact avec une partie de la première zone. On peut ainsi améliorer la résistance thermomécanique du module photovoltaïque tout en minimisant la surface de la zone de recouvrement par rapport à la surface de l'unité photovoltaïque.

Selon un exemple, la zone de recouvrement est en contact avec uniquement la deuxième zone. Ainsi, on limite les effets d'ombrage sur les cellules photovoltaïques.

Selon un exemple, ledit au moins un dispositif de fixation comprend un matériau adhésif. Cela permet, de maintenir le dispositif de fixation en position au sein du module. On améliore ainsi la résistance thermomécanique.

Selon un exemple, ledit au moins un dispositif de fixation est une colle.

Selon un exemple, au moins une couche de protection comprend au moins un ergot formant ledit au moins un dispositif de fixation, ledit au moins un ergot étant configuré de sorte à transmettre à l'unité photovoltaïque une force appliquée sur ladite au moins une couche de protection. Cela permet, à la fois de maintenir une stabilité de l'unité photovoltaïque vis-à-vis des couches de protection tout en permettant d'améliorer la résistance thermomécanique.

Selon un exemple, ledit moins un ergot est dans le même matériau que celui de ladite au moins une couche de protection. Cela permet ainsi de limiter les éléments supplémentaires à prendre en compte afin de s'assurer d'une bonne résistance thermomécanique du module photovoltaïque.

Selon un exemple, au moins l'une parmi la face interne de la première couche de protection et la face interne de la deuxième couche de protection comprend au moins un élément d'assemblage du type mâle ou femelle et l'autre parmi la face interne de la deuxième couche de protection et la face interne de la première couche de protection comprend au moins un élément complémentaire, ledit moins un élément d'assemblage étant configuré de sorte à coopérer avec ledit au moins un élément complémentaire pour assembler les première et deuxième couches de protection entre elles. Cela permet, d'assurer un bon alignement entre la première couche de protection et la deuxième couche de protection. De façon additionnelle, cela permet de s'assurer que l'unité photovoltaïque est bien maintenue dans le logement du module photovoltaïque. Ainsi, on garantit une stabilité de l'unité photovoltaïque au sein de l'empilement.

Selon un exemple, au moins l'une des première et deuxième couche de protection comprend un matériau polymère. L'invention permet donc d'améliorer la résistance thermomécanique des modules présentant une couche qui n'est pas en verre. Si la face avant est en verre, la résistance thermomécanique est également améliorée.

Selon un exemple, la première couche de protection et la deuxième couche de protection sont uniquement en polymère. L'invention permet donc d'améliorer la résistance thermomécanique des modules légers, c'est-à-dire ne présentant pas de couche protectrice en verre.

Selon un exemple, avant la fourniture de l'empilement, le procédé comprend une étape de lamination de l'unité photovoltaïque. L'unité photovoltaïque subit donc une lamination avant insertion dans l'une des couches de protection de sorte à éviter une lamination du module photovoltaïque.

Selon un exemple, la fourniture de l'empilement comprend une étape de fixation de la première couche de protection sur la deuxième couche de protection.

Selon un exemple, une étape de positionnement d'au moins un élément d'assemblage entre la face interne de la première couche de protection et la face interne de la deuxième couche de protection avant l'étape de fixation. Cela permet, de fixer la première couche de protection à la deuxième couche de protection tout en permettant le découplage mécanique entre les couches de protection et l'unité photovoltaïque.

Selon un exemple, la fixation de la première couche de protection sur la deuxième couche de protection est réalisée à froid. Cela permet d'éviter une lamination et donc une déformation de l'encapsulant.

Il est précisé que, dans le cadre de la présente invention, les termes « sur », « surmonte », « recouvre », « sous-jacent », en « vis-à-vis », « au regard » et leurs équivalents ne signifient pas forcément « au contact de ». Ainsi par exemple, le dépôt, le report, le collage, l'assemblage ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

Dans le cadre de la présente invention, un objet ou un matériau « transparent » signifie que l'objet ou le matériau laisse passer au moins 80% voire 90% de l'intensité lumineuse du faisceau lumineux en moyenne sur la gamme de longueurs d'ondes comprise entre 300 et 1200 nm, préférentiellement entre 300 et 2500 nm (nanomètre). Dans le cadre de la présente invention, un objet ou un matériau « semi-transparent » signifie que l'objet ou le matériau laisse passer en moyenne au moins 30% de l'intensité lumineuse du faisceau lumineux sur la gamme de longueurs d'ondes comprises 300 et 1200 nm, préférentiellement entre 300 et 2500 nm.

Dans la description qui suit, sauf indication contraire, lorsqu'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", "latéral", etc., il est fait référence à l'orientation des figures correspondantes, étant entendu que, dans la pratique, les dispositifs et assemblages décrits peuvent être orientés différemment.

Dans la présente description lorsque l'on parle de déplacement d'une couche ou d'un logement on entend une déformation au moins en partie de cette couche ou d'une partie ou de la totalité du logement.

De même lorsqu'on indique qu'un élément est situé au droit d'un autre élément, cela signifie que ces deux éléments sont situés sur une même ligne perpendiculaire au plan principal dans lequel s'étend principalement une face du substrat, c'est-à-dire sur une même ligne orientée verticalement sur les figures.

Les termes « sensiblement », « environ », « de l'ordre de » signifient « à 10% près, de préférence à 5% près » ou, lorsqu'il s'agit d'une orientation angulaire, « à 10° près ». Ainsi, une direction sensiblement normale à un plan signifie une direction présentant un angle de 90±10° par rapport au plan.

On utilisera également un repère dont la direction longitudinale ou arrière/avant correspond à l'axe X, la direction transversale ou droite/gauche correspond à l'axe Y et la direction verticale ou bas/haut correspond à l'axe Z.

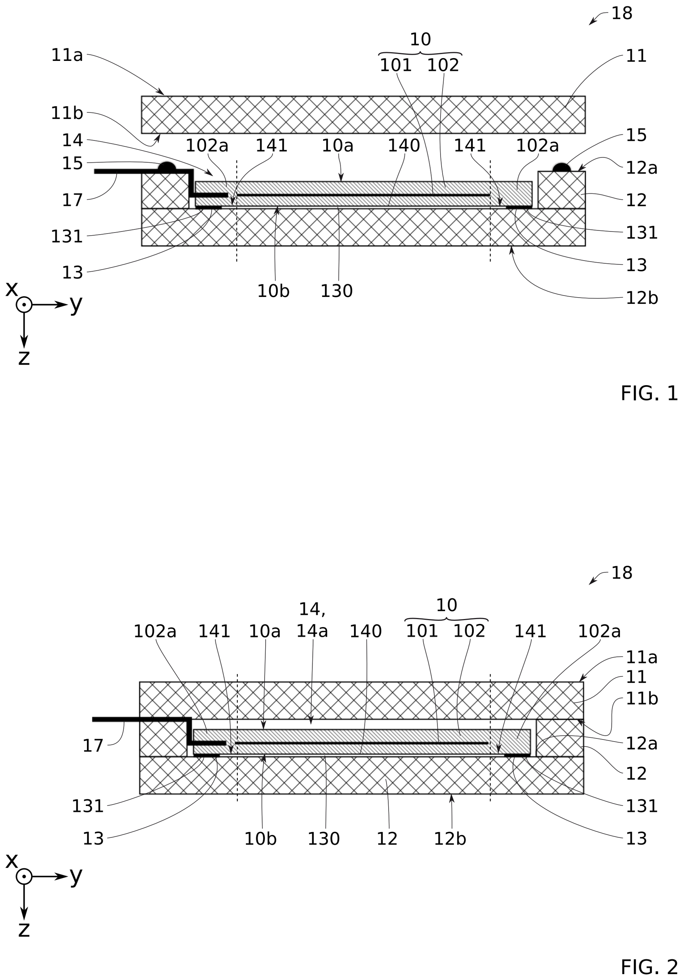

La présente invention concerne un module photovoltaïque 1. Le module photovoltaïque va maintenant être décrit en référence aux figures 1 à 5 et 6A, 6B.

Le module photovoltaïque 1 comprend ainsi un empilement 18 comportant successivement selon une direction Z, dite d'empilement, au moins une première couche de protection 11, une unité photovoltaïque 10 et une deuxième couche de protection 12.

L'unité photovoltaïque 10 comprend une couche d'encapsulant 102 et une chaîne de cellules photovoltaïques 101 électriquement interconnectées. La chaîne de cellules photovoltaïques 101 étant au moins en partie, et de préférence entièrement, noyée au sein de la couche d'encapsulant 102.

Selon un exemple, les cellules photovoltaïques de la chaîne 101 pourront être des cellules à base de silicium cristallin. Elles peuvent alors être interconnectées via des éléments d'interconnections 17 tels que des fils ou des rubans. Les cellules de la chaîne 101 peuvent également être reliées électriquement entre elles par chevauchement, l'une en contact avec l'autre, selon une disposition en tuiles appelée « shingle » en langue anglaise, c'est-à-dire en bardeau. Les cellules photovoltaïques de la chaîne 101 pourront selon un autre exemple être des cellules en couches minces.

Selon un exemple, l'encapsulant 102 comprend un matériau polymère tel qu'un matériau thermoplastique ou partiellement réticulé. Ainsi, l'encapsulant 102 peut comprendre un matériau pris parmi du silicone, du polyoléfine thermoplastique (TPO), un poly-oxy-éthylène (POE), de l'éthylène Vinyle acétate (EVA) ou du polyuréthane thermoplastique (TPU). l'encapsulant 102 permet ainsi de protéger efficacement la chaine de cellules photovoltaïques 101 des déformations thermomécaniques pouvant impacter le module 1.

La première couche de protection 11 et la deuxième couche de protection 12 présentent respectivement deux faces internes 11b, 12a. Ainsi la première couche de protection 11 présente une première face interne 11b et la deuxième couche de protection 12 présente une deuxième face interne 12a distincte de la première face interne 11b. La face interne 11b de la première couche de protection 11 et la face interne 12a de la deuxième couche de protection 12 sont tournées au regard de l'unité photovoltaïque 10.

Plus précisément, la couche d'encapsulant 102 présente une première face externe 10a tournée au regard de la face interne 11b de la première couche de protection 11. De manière similaire, la couche d'encapsulant 102 présente une deuxième face externe 10b tournée au regard de la face interne 12a de la deuxième couche de protection 12.

Ainsi, selon un exemple, l'unité photovoltaïque 10 présente une épaisseur, selon la direction d'empilement Z, entre la première face externe 10a et la deuxième face externe 10b de l'encapsulant 102. L'unité photovoltaïque 10 peut alors présenter une épaisseur comprise entre 50 et 3000 µm (micromètre), de préférence entre 200 et 1200 µm.

Le module photovoltaïque 1 comprend également au moins un dispositif de fixation 13. Par exemple, un dispositif de fixation 13 est situé entre au moins une face externe 10a, 10b de l'unité photovoltaïque 10 et la face interne 11b, 12a tournée au regard de ladite au moins une face externe 10a, 10b.

Les première et deuxième couches de protection 11, 12 forment un logement 14 au sein duquel sont placés l'unité photovoltaïque 10 et au moins un dispositif de fixation 13.

Au moins une face externe 10a, 10b de l'unité photovoltaïque 10 comprend une première zone 140 située au droit, selon une direction parallèle à la direction d'empilement, de la chaîne de cellules photovoltaïques 101, et une deuxième zone 141 entourant la première zone 140.

En particulier, au moins un dispositif de fixation 13 présente une zone de recouvrement 131 en contact avec ladite au moins une face externe 10a, 10b de l'unité photovoltaïque 10. La zone de recouvrement 131 est en contact avec au moins une face externe 10a, 10b de l'unité photovoltaïque 10. Additionnellement, la zone de recouvrement 131 est en contact avec la deuxième zone 141.

La zone de recouvrement 131 présente une surface inférieure ou égale à 10% de la surface de ladite au moins une face externe 10a, 10b de l'unité photovoltaïque 10. De préférence, la surface de la zone de recouvrement 131 est inférieure à 5%, de préférence inférieure à 1% de la surface de l'au moins une face externe 10a, 10b de l'unité photovoltaïque 10.

Ainsi, le dispositif de fixation 130 est configuré de sorte à autoriser un déplacement d'une face interne 11b, 12a au sein du logement 14. On entend ici par déplacement d'une face interne 11b, 12a au sein du logement 14, une déformation au moins en partie de la face interne 11b, 12a au sein du logement 14. On entend ici par au sein du logement 14, une déformation vers l'intérieur du logement 14. Ainsi, la déformation au sein du logement 14 peut être configurée de sorte à réduire le volume 14a du logement 14.

Ainsi, la structure mécanique du module photovoltaïque 1 autorise un comportement mécanique indépendant entre les cellules de la chaîne 101 et la structure mécanique du module composée des première 11 et deuxième 12 couches de protection.

Selon un exemple, la première couche de protection 11 peut alors s'étendre dans un plan perpendiculaire à la direction d'empilement Z. La première couche de protection 11 peut également s'étendre sur une épaisseur, suivant la direction d'empilement Z, d'une face externe 11a jusqu'à la face interne 11b de première couche de protection 11. La première couche 11 permet alors de protéger les cellules photovoltaïques des chocs. L'épaisseur de la première couche de protection 11 peut alors être comprise entre 0,5 et 20 mm (millimètres), de préférence entre 1 et 2 mm.

Selon un exemple, la première couche 11 est un matériau polymère. Typiquement, la première couche 11 peut être en un matériau au moins en partie transparent. Ainsi, la première couche 11 permet de laisser passer les rayonnements lumineux afin qu'ils atteignent les cellules photovoltaïques. De préférence, la première couche 11 peut être totalement en matériau transparent.

Selon un exemple, la deuxième couche de protection 12 peut alors s'étendre dans un plan perpendiculaire à la direction d'empilement. La deuxième couche de protection 12 peut également s'étendre sur une épaisseur, suivant la direction d'empilement Z, de la face interne 12a jusqu'à une face externe 12b de deuxième couche de protection 12. La deuxième couche de protection 12 permet alors de protéger les cellules photovoltaïques des chocs. L'épaisseur de la deuxième couche de protection 12 peut alors être comprise entre 0,5 et 20 mm (millimètres), de préférence entre 1 et 2 mm.

Selon un exemple, la deuxième couche 12 est un matériau polymère. Typiquement, dans le cas de cellules mono-faciales, la deuxième couche 12 peut être en un matériau opaque et/ou réfléchissant. Dans le cas de cellules bifaciales, la deuxième couche 12 peut être en un matériau au moins en partie transparent. Cela permet de laisser passer les rayonnements lumineux en direction des deux faces externes 10a, 10b de la couche d'encapsulant 102 afin qu'ils atteignent les cellules photovoltaïques. La deuxième couche 12 peut être totalement en matériau transparent.

Selon un exemple, la première couche de protection 11 et la deuxième couche de protection 12 sont uniquement en polymère. L'invention permet donc d'améliorer la résistance thermomécanique des modules 1 léger. Un module 1 léger est un module ne présentant pas de couche protectrice en verre.

Ainsi, la première couche de protection 11 et/ou la deuxième couche de protection 12 peuvent être en un matériau pris parmi le polypropylène (PP), les polyuréthanes (PUR), le chlorure de polyvinyle (PVC ou vinyle), l'acrylonitrile butadiène styrène (ABS), les polyamides (PA/Nylon 6/6, Nylon 6), le polystyrène (PS), le polyéthylène (PE), le polyoxyméthylène (POM), le polycarbonate (PC), l'acrylique (PMMA), le polytéréphtalate de butylène (PBT), le polyéthylène téréphtalate (PET), l'acrylonitrile styrène acrylate (AAS), le cyclic olefin copolymer (COC), copolymère styrène-acrylonitrile (SAN), éthylène-tétra-fluoro-éthylène (ETFE), éthylène chloro-trifluoro-éthylène (ECTFE), polyfluorure de vinylidène (PVDF), les résines époxy, le polyester, ou le polyuréthane avec renforts fibres possible.

En particulier, le matériau utilisé pour les couches de protection 11, 12 peut avoir un coefficient thermique d'expansion (CTE) supérieur ou égal au coefficient thermique d'expansion de la chaine de cellules photovoltaïques 101, par exemple le polycarbonate.

Avantageusement, les première 11 et deuxième 12 couches de protection créent ainsi une coque de protection autour de l'unité photovoltaïque 10 afin d'assurer une résistance aux chocs mécaniques.

Selon un exemple, le logement 14 est configuré de sorte à présenter un volume 14a supérieur à un volume de l'unité photovoltaïque 10. Le volume 14a du logement 14 est supérieur au volume de l'unité photovoltaïque 10 afin de s'assurer d'avoir un volume de séparation 130 entre l'unité photovoltaïque 10 et les couches de protection 11,12.

En d'autres termes, le logement 14 est délimité par la face interne de la première couche 11 et par la face interne de la deuxième couche 12. Ainsi, le logement 14 présente des contours fermés. Les contours fermés du logement 14 peuvent se déformer si des contraintes sont appliquées aux couches 11 et 12 formants le logement 14. Ainsi, un déplacement ou une déformation au sein du logement 14 s'entend comme une déformation des contours fermés du logement 14 vers l'intérieur du logement 14. La déformation du logement 14 peut être configurée de sorte à réduire le volume 14a du logement 14.

De préférence, ledit au moins un dispositif de fixation 13 est au contact de ladite au moins une face externe 10a, 10b de l'unité photovoltaïque 10 et de ladite face interne 11b, 12a. Par exemple, le dispositif de fixation 13 est configuré pour créer le volume de séparation 130 entre une face externe 10a, 10b et la face interne 11b, 12a située au regard de ladite face externe 10a, 10b. De façon générale, le dispositif de fixation 13 permet de fixer au moins une couche de protection 11, 12 sur la zone de recouvrement 131 correspondant à une zone localisée d'au moins une face externe 10a, 10b de l'unité photovoltaïque 10. En d'autres termes, en l'absence de chocs mécaniques ou d'une déformation thermomécanique de l'une des couches du module 1, ladite face externe 10a, 10b n'est pas fixée directement à ladite face interne 11b, 12a sur au moins une partie de la surface de la face externe 10a, 10b. Elle est fixée mécaniquement à l'une des couches de protection 11, 12 uniquement par l'intermédiaire du dispositif de fixation 13. Cela permet ainsi d'éviter un couplage mécanique direct entre les couches de protection 11, 12 et la chaîne de cellules. Le module ne subit ainsi ni chocs mécaniques, ni déformation thermomécanique. De ce fait, au moins un dispositif de fixation 13 est configuré pour empêcher un contact surfacique direct et « pleine plaque » de l'unité photovoltaïque 10 avec au moins l'une des couches de protection 11, 12, sur toutes les surfaces externes de l'unité 10. Ainsi, le dispositif de fixation 13 empêche que les déformations d'au moins une couche de protection 11, 12 s'imposent à l'unité photovoltaïque 10. On entend ici par déformation, toutes déformations thermomécaniques, différentielles, dues aux chocs ou déformations structurelles liées à la fixation du module 1. En d'autres termes, on évite la transmission directe des contraintes subies par au moins l'une des couches de protection 11, 12 à l'unité photovoltaïque 10. De préférence, le module comprend au moins deux dispositifs de séparation 13 respectivement situés entre une face externe de l'unité et une face interne de chaque couche de protection, pour améliorer le découplage mécanique entre les couches de protection 11, 12 et l'unité photovoltaïque 10.

L'au moins un dispositif de fixation 13 peut être indifféremment positionné sur au moins une face externe 10a, 10b de l'unité photovoltaïque 10 ou sur ladite face interne 11b, 12a.

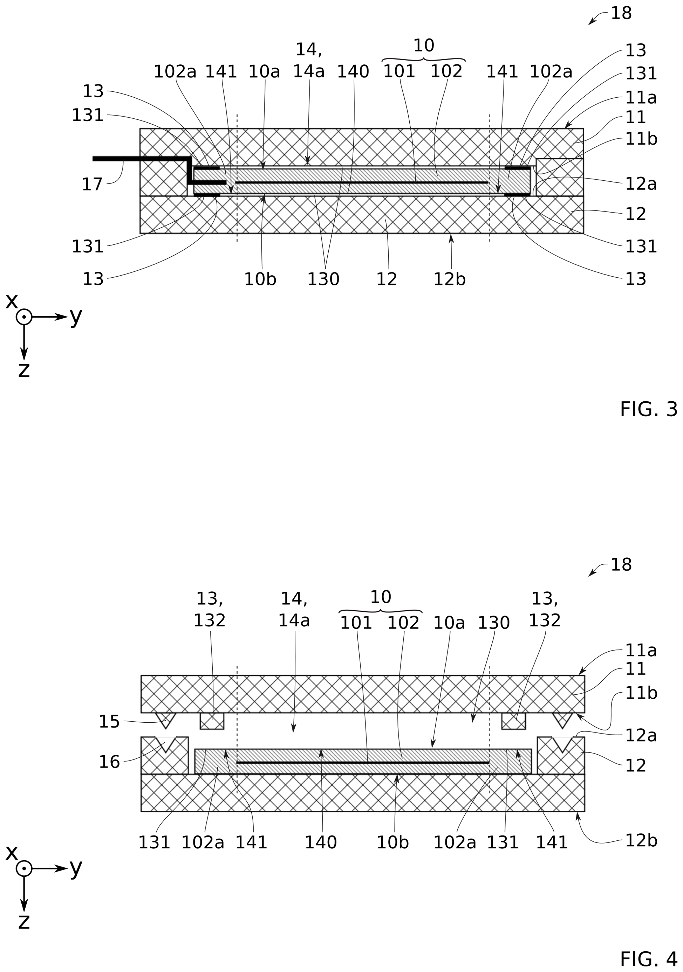

Selon un exemple illustré en figure 3, le module 1 comprend un premier dispositif de fixation 13 configuré de sorte à être au contact de la face interne 11b de la première couche de protection 11 et de la première face externe 10a de l'encapsulant 102. Le module 1 peut aussi comprendre un deuxième dispositif de fixation 13 au contact de la face interne 12a de la deuxième couche de protection 12 et de la deuxième face externe 10b de l'encapsulant 102. On améliore ainsi le découplage entre les première 11 et deuxième 12 couches de protection et l'unité photovoltaïque 10. Plus précisément, le dispositif de fixation 13 permet de fixer mécaniquement l'unité photovoltaïque 10 à au moins l'une des couches de protection. De manière préférentielle, cette fixation rend solidaire l'unité photovoltaïque 10 avec au moins l'une des couches de protection 10, 11. Cette fixation étant de préférence ponctuelle et non sur toute la surface de l'unité photovoltaïque 10. Ainsi, dans certaines conditions la déformation d'une couche de protection, présentant de préférence un module d'Young supérieur à 1 GPa (Giga Pascal) n'impose pas la déformation de la couche d'encapsulant, présentant de préférence un module d'Young inférieur à 1 GPa. Au contraire, ce sont donc les cellules photovoltaïques 101 qui jouent le rôle de substrat de contrainte imposant leur déplacement à l'encapsulant 102. Ainsi, le module 1 présente une résistance thermomécanique améliorée.

Selon un exemple, ladite au moins une face externe 10a, 10b de l'unité photovoltaïque 10 comprend une première zone 140 située au droit, selon une direction parallèle à la direction d'empilement Z, de la chaîne de cellules photovoltaïques 101. Plus précisément, la première zone 140 est illustrée sur les figures 1 à 4 entre les pointillés verticaux.

Selon un exemple, ladite au moins une face externe 10a, 10b de l'unité photovoltaïque 10 comprend également une deuxième zone 141 entourant la première zone 140. De manière similaire, la deuxième zone 141 s'étend dans un plan perpendiculaire à la direction d'empilement Z au niveau d'une portion 102a de l'encapsulant 102. Ainsi, la deuxième zone 141 est illustré sur les figures 1 à 4 entre les pointillés et les bords de l'unité photovoltaïque 10.

Selon un exemple, ledit au moins un dispositif de fixation 13 présente une zone de recouvrement 131 en contact avec ladite au moins une face externe 10a, 10b de l'unité photovoltaïque 10. La zone de recouvrement 131 peut être au moins en partie en contact avec la deuxième zone 141 et présenter une partie de recouvrement en contact avec la première zone 140. Ainsi, la partie de recouvrement peut avoir une surface inférieure ou égal à 10%, de préférence inférieur à 5%, de préférence inférieur à 3%, de préférence inférieur à 1% de la surface de la première zone 140.

Selon un exemple, la zone de recouvrement 131 est en contact avec uniquement la deuxième zone 141. De préférence, la zone de recouvrement 131 est en contact avec une surface inférieure de la deuxième zone 141. De préférence, la zone de recouvrement 131 est non nulle. Cela permet ainsi de minimiser au maximum les risques d'ombrage des cellules photovoltaïques 101 et donc de ne pas limiter les performances du module photovoltaïque 1.

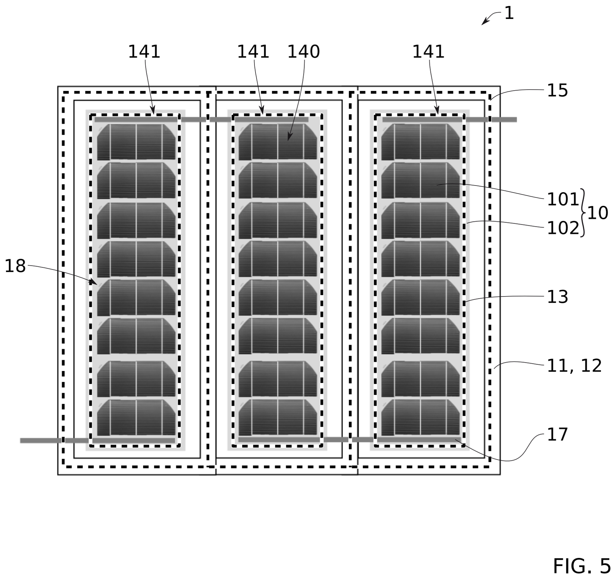

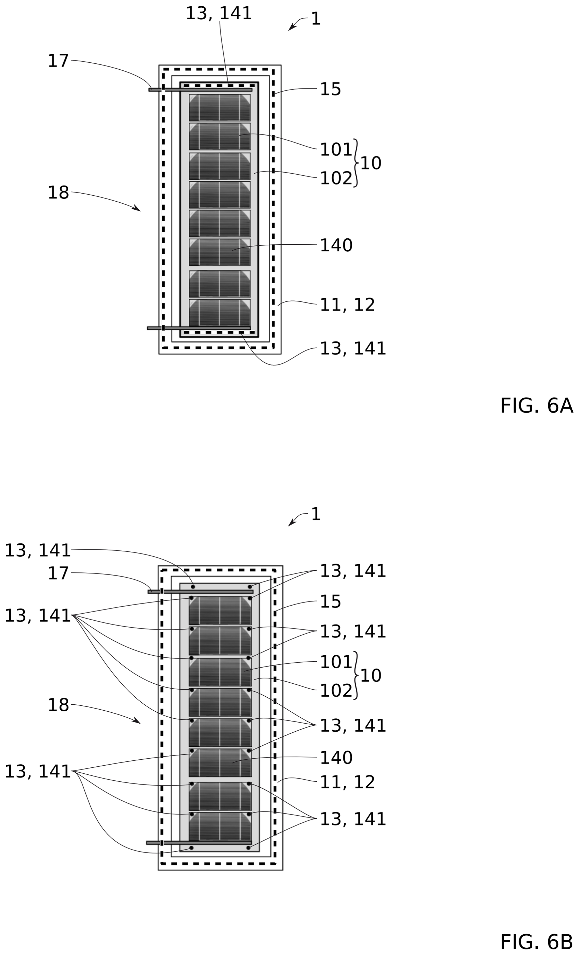

Selon un exemple, illustré en figure 5, l'au moins un dispositif de fixation 13 comprend un cadre entourant la deuxième zone 141. Plus précisément, le dispositif de fixation 13 est positionné de sorte à encadrer l'unité photovoltaïque 10 dans la deuxième zone 141. Cela permet d'améliorer la stabilité de l'unité photovoltaïque 10 vis-à-vis d'au moins une des couches 11, 12 de protection. Le dispositif de fixation 13 est illustré de façon non limitative aux figures 5, 6A et 6B par des pointillés.

Selon un exemple, illustré en figure 6A, l'au moins un dispositif de fixation 13 comprend au moins deux portions distinctes s'étendant le long respectivement de deux bords opposés de la deuxième zone 141. Plus précisément, le dispositif de fixation 13 est positionné de sorte à s'étendre sur deux bords opposés de l'unité photovoltaïque 10 dans la deuxième zone 141. Cela permet de créer un maintien linéaire de l'unité photovoltaïque 10 sur au moins une des couches 11, 12 de protection. Ce qui permet de limiter la quantité de matière pour alléger le module 1.

Selon un exemple, illustré en figure 6B, l'au moins un dispositif de fixation 13 comprend une pluralité de plots distincts entourant la deuxième zone 141. Plus précisément, le dispositif de fixation 13 est constitué d'une pluralité de points ponctuels positionnés dans la deuxième zone 141. Cela permet de créer un maintien ponctuel de l'unité photovoltaïque 10 sur au moins une des couches 11, 12 de protection. Cela permet additionnellement de minimiser la surface nécessaire pour créer un volume de séparation 130.

Selon un exemple, l'au moins un dispositif de fixation 13 peut être positionné sur ladite face interne 11b, 12a. Plus précisément, l'au moins un dispositif de fixation 13 peut être positionné sur ladite face interne 11b, 12a avant l'assemble du module photovoltaïque 1. Ainsi, l'assemblage du module photovoltaïque 1 peut être facilité.

Selon un exemple, l'au moins un dispositif de fixation 13 peut être positionné sur l'au moins une face externe 10a, 10b de l'unité photovoltaïque 10. Le positionnement du dispositif de fixation 13 peut être réalisé avant l'assemblage de l'unité photovoltaïque 10. Ainsi, le positionnement de l'unité photovoltaïque 10 dans le logement 14 est facilité et permet de s'assurer de la création du volume de séparation 130.

Selon un premier mode de réalisation, ledit au moins un dispositif de fixation 13 comprend un matériau adhésif. Le matériau adhésif peut être par exemple une colle. Cela permet de maintenir l'unité photovoltaïque 10 sur les couches de protection 11, 12 pour améliorer la résistance thermomécanique.

Selon un exemple, ledit au moins un dispositif de fixation 13 est une colle. La colle peut être prise parmi de l'époxy, du polyuréthane, un joint tel du polyvinyle de butyral (PVB).

Selon un deuxième mode de réalisation, au moins une couche de protection 11, 12 comprend au moins un ergot 132 formant ledit au moins un dispositif de fixation 13. De manière générale un ergot 132 est situé en saillie de la face interne 11b, 12a d'une couche de protection 11, 12. L'au moins un ergot 132 peut être configuré de sorte à transmettre à l'unité photovoltaïque 10 une force appliquée sur la couche de protection 11, 12. Cela permet, à la fois de maintenir l'unité photovoltaïque 10 sur les couches de protection 11, 12 sans colle tout en créant le volume de séparation 130 permettant d'améliorer la résistance thermomécanique.

Selon un exemple, ledit au moins un ergot 132 est dans le même matériau que celui de la couche de protection 11, 12. Cela permet de s'assurer d'une bonne résistance thermomécanique du module photovoltaïque 10. De plus, l'au moins un ergot 132 présente une épaisseur, l'épaisseur de l'au moins un ergot 132 additionnée une épaisseur de l'encapsulant 102 doit être supérieur à une épaisseur du logement 14. Cela permet ainsi d'avoir un effet de compression maintenant ainsi le module photovoltaïque 10 en position dans le logement 14.

Selon un autre mode de réalisation non représenté, le dispositif de fixation 13 peut être positionné sur une périphérie du module photovoltaïque 1. Le dispositif de fixation 13 peut additionnellement être positionné de manière ponctuelle entre chaque unité 10 du module 1. Cela permet ainsi de s'assurer de garder le volume de séparation 130 sur l'ensemble du module 1.

Ainsi, selon un exemple, un unique dispositif de fixation 13 est positionné seulement entre la face interne 12a de deuxième couche 12 et la deuxième face externe 10b de l'unité photovoltaïque 10. Ainsi un unique volume de séparation 130 pourra être délimité entre la face interne 12a de deuxième couche 12 et la deuxième face externe 10b de l'unité photovoltaïque 10. Cet exemple est illustré par la figure 2.

Selon une variante, un premier dispositif de fixation 13 est positionné entre la face interne 12a de deuxième couche 12 et la deuxième face externe 10b de l'unité photovoltaïque 10 et un deuxième dispositif de fixation 13 est positionné entre la face interne 11b de la première couche de protection 11 et la première face externe 10a de l'unité photovoltaïque 10. Ainsi un premier volume de séparation 130 pourra être délimité entre la face interne 12a de deuxième couche 12 et la deuxième face externe 10b de l'unité photovoltaïque 10 et un deuxième volume de séparation 130 pourra être délimité entre la face interne 11b de la première couche de protection 11 et la première face externe 10a de l'unité photovoltaïque 10. Cet exemple est illustré par la figure 3.

Enfin, selon un autre exemple, un unique dispositif de fixation 13 est positionné seulement entre la face interne 11b de première couche de protection 11 et la première face externe 10a de l'unité photovoltaïque 10. Ainsi un unique volume de séparation 130 pourra être délimité entre la face interne 11b de première couche de protection 11 et la première face externe 10a de l'unité photovoltaïque 10. Cet exemple est illustré par la figure 4.

Selon un exemple, le volume de séparation 130 est configuré de sorte à contenir un fluide compressible. Cela permet d'amortir un déplacement d'une couche de protection 11, 12 au sein d'un volume de séparation 130. De manière analogue, cela permet d'autoriser une déformation d'une couche de protection 11, 12 vers le volume de séparation 130. Ainsi, la déformation d'une couche de protection 11, 12 eu sein du volume de séparation 130 peut être configurée de sorte à réduire le volume de séparation 130. Ainsi on limite une déformation de l'encapsulant 102 en réponse à une déformation thermomécanique, ou mécanique, des couches de protection 11, 12 sans impacter les cellules photovoltaïques 101. Ainsi, on évite un endommagement des cellules photovoltaïques 101 et une perte de performance du module 1.

Selon un exemple, le fluide compressible est choisi parmi un gaz ou un liquide. Le gaz ou le liquide compressible pourra alors permettre d'autoriser les déplacements d'au moins une couche de protection 11, 12 tout en amortissant les contraintes thermomécaniques et/ou mécaniques. Le gaz ou le liquide compressible pourra alors permettre d'autoriser les déformations d'au moins une couche de protection 11, 12 tout en amortissant les contraintes thermomécaniques et/ou mécaniques.

Selon un exemple, le volume de séparation 130 est configuré de sorte à être rempli d'air. Préférentiellement, le volume de séparation 130 est rempli avec de l'air sec ou un gaz inerte. L'utilisation de l'air permet de faciliter l'assemblage.

Selon un exemple, le module 1 comprend un évent et une membrane anti-retour, non illustrés à des fins de simplification. La membrane permet avantageusement de réaliser un équilibrage des pression partielles. L'évent et la membrane anti-retour peuvent alors être configurés pour permettre une évacuation du fluide compressible, de préférence du gaz, vers l'extérieur du module photovoltaïque 1. Cela permet, d'évacuer le fluide présent dans le volume de séparation 130 qui pourrait être mis sous pression lors des différents changements thermiques du module photovoltaïque 1. Par exemple, l'évent peut être formé au sein d'une couche de protection 11, 12, par exemple en formant un trou traversant la couche de protection 11, 12. L'évent peut également être formé sur un bord du module photovoltaïque 10.

Selon un exemple, la première couche de protection 11 est positionnée sur la deuxième couche de protection 12 bord à bord afin de fermer le module photovoltaïque 1. Afin de solidariser la première couche de protection 11 avec la deuxième couche de protection 12, un élément d'assemblage 15, illustré en figure 1, peut être positionné. Plus précisément, un élément d'assemblage 15 est positionné sur l'au moins une parmi la face interne 11b de la première couche de protection 11 et la face interne 12a de la deuxième couche de protection 12.

Selon un exemple, l'au moins un élément d'assemblage 15 est un matériau polymère adhésif. De préférence l'au moins un élément d'assemblage 15 est une colle. La colle peut être prise parmi de l'époxy, du polyuréthane, un joint. De façon non limitative, l'élément d'assemblage 15 est illustré aux figures 5, 6A et 6B par des pointillés.

Selon un exemple, illustré en figure 4, au moins l'une parmi la face interne 11b de la première couche de protection 11 et la face interne 12a de la deuxième couche de protection 12 comprend au moins un élément d'assemblage 15 du type mâle ou femelle et l'autre parmi la face interne 12a de la deuxième couche de protection 12 et la face interne 11b de la première couche de protection 11 comprend au moins un élément complémentaire 16. Ledit au moins un élément d'assemblage 15 étant configuré de sorte à coopérer avec ledit au moins un élément complémentaire 16 pour assembler les première 11 et deuxième 12 couches de protection entre elles. Ainsi, cela peut assurer un bon alignement entre la première couche de protection 11 et la deuxième couche de protection 12. Ce bon alignement permet de s'assurer que lorsque le module 1 est assemblé, on garantit le découplage mécanique entre les couches de protection 11, 12 et l'unité photovoltaïque 10. De façon additionnelle, cela permet de s'assurer que l'unité photovoltaïque 10 est bien maintenue dans le logement du module photovoltaïque 1. De plus cette fermeture permet additionnellement d'adresser de grandes tailles de module photovoltaïque 1.

Selon un exemple, les fils d'interconnections 17 du module photovoltaïque 1 peuvent être reliés à une boite de jonction. La boite de jonction permet de fournir le courant à un système externe au module 1. La boite de jonction permet également de relier électriquement plusieurs modules 1 entre eux. Additionnellement, la boite de jonction permet d'insérer des diodes de dérivation.

Le procédé de fabrication d'un module photovoltaïque 1 comprend une fourniture d'un empilement 18. L'empilement 18 comportant successivement selon une direction Z, dite d'empilement, au moins une première couche de protection 11. L'empilement 18 comprenant également une unité photovoltaïque 10, l'unité photovoltaïque 10 comprenant une couche d'encapsulant 102 et une chaîne de cellules photovoltaïques 101 électriquement interconnectées. La chaîne de cellules photovoltaïques 101 étant au moins en partie noyée au sein de la couche d'encapsulant 102. L'empilement 18 comprenant aussi une deuxième couche de protection 12. Les première et deuxième couches de protection 11, 12 présentent respectivement deux faces internes 11b, 12a tournées au regard de l'unité photovoltaïque 10. La couche d'encapsulant 102 présentent une première face externe 10a tournée au regard de la face interne 11b de la première couche de protection 11 et une deuxième face externe 10b tournée au regard de la face interne 12a de la deuxième couche de protection 12.

Le procédé de fabrication comprend également un placement d'au moins un dispositif de fixation 13 entre au moins une face externe 10a, 10b de l'unité photovoltaïque 10 et la face interne 11b, 12a tournée au regard de ladite au moins une face externe 10a, 10b, de sorte à créer un volume de séparation 130. Le volume de séparation 130 peut alors être configuré pour permettre un déplacement de ladite face interne 11b, 12a au sein du volume de séparation 130. On entend par déplacement de ladite face interne 11b, 12a, une déformation de au moins une partie de ladite face interne 11b, 12a. On entend par au sein du volume de séparation 130, une déformation vers l'intérieur du volume de séparation 130. Ainsi, la déformation de au moins une partie de ladite face interne 11b, 12a est configurée de sorte à réduire le volume de séparation 130.

Selon un exemple, le placement comprend une mise en contact dudit au moins un dispositif de fixation 13 avec ladite au moins une face externe 10a, 10b de l'unité photovoltaïque 10 et avec ladite face interne 11b, 12a.

Selon un exemple, avant la fourniture de l'empilement 18, le procédé comprend une étape de lamination de l'unité photovoltaïque 10. L'unité photovoltaïque 10 subit donc une lamination avant insertion entre les couches de protection 11, 12 de sorte à éviter une lamination du module photovoltaïque. Cela permet d'éviter adhésion de l'encapsulant 102 dans le volume de séparation 130 et donc d'empêcher un contact surfacique de l'unité photovoltaïque 10 avec les couches de protection 11, 12, sur toutes les surfaces externes de l'unité 10.

Selon un exemple, la fourniture de l'empilement 18 comprend une étape de fixation de la première couche de protection 11 sur la deuxième couche de protection 12. Ainsi, le module 1 devient un seul dispositif plus facilement transportable.

Selon un exemple, une étape de positionnement d'au moins un élément d'assemblage 15 entre la face interne 11b de la première couche de protection 11 et la face interne 12a de la deuxième couche de protection 12 avant l'étape de fixation. Cela permet, de stabiliser l'ensemble des couches 11, 12, 102 de l'empilement 18 du module photovoltaïque et permet d'éviter l'insertion d'élément additionnel dans le logement 14.

Selon un exemple, la fixation de la première couche de protection 11 sur la deuxième couche de protection 12 est réalisée à froid. Cela permet d'éviter une lamination et donc une déformation de l'encapsulant 102 pour empêcher que l'encapsulant 102 remplisse totalement le volume du logement 14. Cela permet également d'éviter à l'encapsulant 102 d'adhérer à des surfaces délimitant le volume de séparation 130.

Selon un exemple, la fourniture de l'empilement 18 comprend une étape d'injection d'un fluide compressible dans le volume de séparation 130.

Ainsi, selon un exemple, l'empilement 18 est assemblé de sorte à positionner l'unité photovoltaïque 10 sur la deuxième couche de protection 12. La deuxième couche de protection 12 peut alors comprendre un logement 14. Dans ce logement 14 peut être positionné au moins un dispositif de fixation 13 de sorte à créer un volume de séparation 130. Une étape d'injection de fluide compression peut alors être réalisé dans le volume de séparation 130. Ensuite, l'unité photovoltaïque 10 préalablement laminée peut être positionnée en contact dudit au moins un dispositif de fixation 13 créant ainsi le volume de séparation 130. Au moins un autre dispositif de fixation 13 peut être positionné sur l'unité photovoltaïque 10 positionnée dans le logement 14. Ensuite, la première couche de protection 11 peut être positionnée au droit de la deuxième couche de protection 12. Enfin la première couche de protection 11 peut être assemblée à la deuxième couche de protection 12 par des éléments d'assemblage 15.

### REFERENCES NUMERIQUES

1. module photovoltaïque
10. unité photovoltaïque
10a. première face externe de l'unité photovoltaïque
10b. deuxième face externe de l'unité photovoltaïque
101. chaîne de cellules photovoltaïque électriquement interconnectées
102. couche d'encapsulant
102a. portion d'encapsulant
11. première couche de protection
11a. face externe de la première couche de protection
11b. face interne de la première couche de protection
12. deuxième couche de protection
12a. face interne de la deuxième couche
12b. face externe de la deuxième couche
13. dispositif de fixation
130. volume de séparation
131. zone de recouvrement
132. ergot
14. logement
14a. volume de logement
140. première zone
141. deuxième zone
15. élément d'assemblage
16. élément complémentaire
17. fils d'interconnexion
18. empilement

## Revendications

1. Module photovoltaïque (1), comprenant un empilement (18) comportant successivement selon une direction (Z), dite d'empilement, au moins :
• une première couche de protection (11),
• une unité photovoltaïque (10), l'unité photovoltaïque comprenant une couche d'encapsulant (102) et une chaîne de cellules photovoltaïques (101) électriquement interconnectées, la chaîne de cellules photovoltaïques étant au moins en partie noyée au sein de la couche d'encapsulant (102) ; et
• une deuxième couche de protection (12),
les première et deuxième couches de protection (11, 12) présentant respectivement deux faces internes (11b, 12a) tournées en regard et vers l'unité photovoltaïque (10),
la couche d'encapsulant (102) présentant une première face externe (10a) tournée au regard de la face interne (11b) de la première couche de protection (11) et une deuxième face externe (10b) tournée en regard et vers la face interne (12a) de la deuxième couche de protection (12),
**caractérisé en ce que** le module photovoltaïque (1) comprend au moins un dispositif de fixation (13) situé entre au moins une face externe (10a, 10b) de l'unité photovoltaïque (10) et la face interne (11b, 12a) tournée en regard et vers ladite au moins une face externe (10a, 10b), les première et deuxième couches de protection (11, 12) forment un logement (14), le logement (14) étant délimité par la face interne (11b) de la première couche (11) et par la face interne (12a) de la deuxième couche (12), au sein duquel sont placés l'unité photovoltaïque (10) et ledit au moins un dispositif de fixation (13), ledit au moins un dispositif de fixation (13) étant au contact de ladite au moins une face externe (10a, 10b) de l'unité photovoltaïque (10) et de ladite face interne (11b, 12a) et **en ce que** ladite au moins une face externe (10a, 10b) de l'unité photovoltaïque (10) comprend une première zone (140) située au droit, selon une direction parallèle à la direction d'empilement, de la chaîne de cellules photovoltaïques (101), et une deuxième zone (141) entourant la première zone (140), ledit au moins un dispositif de fixation (13) présente une zone de recouvrement (131) en contact avec ladite au moins une face externe (10a, 10b) de l'unité photovoltaïque (10), la zone de recouvrement (131) étant au moins en contact avec la deuxième zone (141) et présente une surface inférieure ou égale à 10% de la surface de ladite au moins une face externe (10a, 10b) de l'unité photovoltaïque (10), le dispositif de fixation (13) étant configuré pour permettre un déplacement de ladite face interne (11b, 12a) au sein du logement (14).

2. Module photovoltaïque (1) selon la revendication précédente dans lequel, le logement (14) est configuré de sorte à présenter un volume (14a) supérieur à celui de l'unité photovoltaïque (10) et de sorte à créer un volume de séparation (130) entre l'unité photovoltaïque (10) et le première couche de protection (11) et/ou la deuxième couche de protection (12).

3. Module photovoltaïque (1) selon la revendication précédente dans lequel, le volume de séparation (130) est configuré de sorte à contenir un fluide compressible.

4. Module photovoltaïque (1) selon l'une quelconque des revendications précédentes, dans lequel la zone de recouvrement (131) est en contact avec uniquement la deuxième zone (141).

5. Module photovoltaïque (1) selon l'une quelconque des revendications 1 à 3, dans lequel la zone de recouvrement (131) présente, en outre, une partie de recouvrement en contact avec une partie de la première zone (140).

6. Module photovoltaïque (1) selon l'une quelconque des revendications précédentes, dans lequel ledit au moins un dispositif de fixation (13) comprend un matériau adhésif.

7. Module photovoltaïque (1) selon l'une quelconque des revendications 1 à 6, dans lequel au moins une couche de protection (11, 12) comprend au moins un ergot (132) formant ledit au moins un dispositif de fixation (13), ledit au moins un ergot (132) étant configuré de sorte à transmettre à l'unité photovoltaïque (10) une force appliquée sur ladite au moins une couche de protection (11, 12).

8. Module photovoltaïque (1) selon la revendication précédente dans lequel, ledit moins un ergot (132) est dans le même matériau que celui de ladite au moins une couche de protection (11, 12).

9. Module photovoltaïque (1) selon l'une quelconque des revendications précédentes, dans lequel au moins l'une parmi la face interne (11b) de la première couche de protection (11) et la face interne (12a) de la deuxième couche de protection (12) comprend au moins un élément d'assemblage du type mâle ou femelle (15) et l'autre parmi la face interne (12a) de la deuxième couche de protection (12) et la face interne (11b) de la première couche de protection (11) comprend au moins un élément complémentaire (16), ledit moins un élément d'assemblage (15) étant configuré de sorte à coopérer avec ledit au moins un élément complémentaire (16) pour assembler les première et deuxième couches de protection (11, 12) entre elles.

10. Module photovoltaïque (1) selon l'une quelconque des revendications précédentes dans lequel, au moins l'une des première (11) et deuxième (12) couche de protection comprend un matériau polymère.

11. Procédé de fabrication d'un module photovoltaïque, comprenant une fourniture d'un empilement (18), l'empilement (18) comportant successivement selon une direction, dite d'empilement, au moins :
• une première couche de protection (11),
• une unité photovoltaïque (10), l'unité photovoltaïque comprenant une couche d'encapsulant (102) et une chaîne de cellules photovoltaïques (101) électriquement interconnectées, la chaîne de cellules photovoltaïques étant au moins en partie noyée au sein de la couche d'encapsulant (102) ; et
• une deuxième couche de protection (12),
les première et deuxième couches de protection (11, 12) présentant respectivement deux faces internes (11b, 12a) tournées au regard de l'unité photovoltaïque (10),
la couche d'encapsulant (102) présentant une première face externe (10a) tournée au regard de la face interne (11b) de la première couche de protection (11) et une deuxième face externe (10b) tournée au regard de la face interne (12a) de la deuxième couche de protection (12),
**caractérisé en ce que** le procédé comprend un placement d'au moins un dispositif de fixation (13) entre au moins une face externe (10a, 10b) de l'unité photovoltaïque (10) et la face interne (11b, 12a) tournée au regard de ladite au moins une face externe (10a, 10b), les première et deuxième couches de protection (11, 12) forment un logement (14), le logement (14) étant délimité par la face interne (11b) de la première couche (11) et par la face interne (12a) de la deuxième couche (12), au sein duquel un placement de l'unité photovoltaïque (10) et dudit au moins un dispositif de fixation (13) est réalisé, ledit au moins un dispositif de fixation (13) étant placé au contact de ladite au moins une face externe (10a, 10b) de l'unité photovoltaïque (10) et de ladite face interne (11b, 12a) et de sorte que ladite au moins une face externe (10a, 10b) de l'unité photovoltaïque (10) comprend une première zone (140) située au droit, selon une direction parallèle à la direction d'empilement, de la chaîne de cellules photovoltaïques (101), et une deuxième zone (141) entourant la première zone (140), ledit au moins un dispositif de fixation (13) présente une zone de recouvrement (131) en contact avec ladite au moins une face externe (10a, 10b) de l'unité photovoltaïque (10), la zone de recouvrement (131) étant au moins en contact avec la deuxième zone (141) et présente une surface inférieure ou égale à 10% de la surface de ladite au moins une face externe (10a, 10b) de l'unité photovoltaïque (10), le dispositif de fixation (13) étant configuré pour permettre un déplacement de ladite face interne (11b, 12a) au sein du logement (14).

12. Procédé selon la revendication précédente dans lequel, la fourniture de l'empilement (18) comprend une étape de fixation de la première couche de protection (11) sur la deuxième couche de protection (12).

13. Procédé selon la revendication précédente dans lequel, le procédé comprend une étape de positionnement d'au moins un élément d'assemblage (15) entre la face interne (11b) de la première couche de protection (11) et la face interne (12a) de la deuxième couche de protection avant l'étape de fixation.
